(19) Europäisches Patentamt / European Patent Office / Office européen des brevets

(11) **EP 2 773 972 B1**

(12) **FASCICULE DE BREVET EUROPEEN**

(45) Date de publication et mention
de la délivrance du brevet:
**06.09.2017 Bulletin 2017/36**

(21) Numéro de dépôt: **12794211.8**

(22) Date de dépôt: **02.11.2012**

(51) Int Cl.:
*G01R 33/24* (2006.01)          *G01R 33/28* (2006.01)
*G01R 33/00* (2006.01)          *G01R 33/02* (2006.01)
*G01R 33/07* (2006.01)

(86) Numéro de dépôt international:
**PCT/EP2012/071734**

(87) Numéro de publication internationale:
**WO 2013/064642 (10.05.2013 Gazette 2013/19)**

(54) **APPAREIL DE SURVEILLANCE DANS UN ENVIRONNEMENT MAGNETIQUE ET PROCEDE ASSOCIE**

VORRICHTUNG ZUR ÜBERWACHUNG IN EINER MAGNETISCHEN UMGEBUNG UND ENTSPRECHENDES VERFAHREN

APPARATUS FOR MONITORING IN A MAGNETIC ENVIRONMENT AND METHOD ASSOCIATED THEREWITH

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **02.11.2011 FR 1159914**

(43) Date de publication de la demande:
**10.09.2014 Bulletin 2014/37**

(73) Titulaires:
• **Université de Lorraine**
  **54052 Nancy Cedex (FR)**
• **Centre Hospitalier Regional de Nancy**
  **54035 Nancy (FR)**

(72) Inventeurs:
• **PASQUIER, Cédric**
  **F-54130 Saint Max (FR)**
• **FELBLINGER, Jacques**
  **F-54850 Mereville (FR)**
• **JOVANOVIC, Slavisa**
  **F-54500 Vandoeuvre-Les-Nancy (FR)**

(74) Mandataire: **Pontet Allano & Associes**
  **Parc Les Algorithmes, Bâtiment Platon**
  **CS 70003 Saint-Aubin**
  **91192 Gif-sur-Yvette Cedex (FR)**

(56) Documents cités:
WO-A1-2006/034551     US-A1- 2002 171 427
US-A1- 2009 140 726     US-B1- 7 688 072

• **JOLANTA KARPOWICZ: "Assessment of induced currents hazards among health care workers operating magnetic resonance scanners â Towards new standardization approach", APPLIED SCIENCES IN BIOMEDICAL AND COMMUNICATION TECHNOLOGIES, 2009. ISABEL 2009. 2ND INTERNATIONAL SYMPOSIUM ON, IEEE, PISCATAWAY, NJ, USA, 24 novembre 2009 (2009-11-24), pages 1-2, XP031596010, ISBN: 978-1-4244-4640-7**
• **JENS GROEBNER ET AL: "MR safety: simultaneous, d/t, and d/dmeasurements on MR-workers up to 7 T", MAGNETIC RESONANCE MATERIALS IN PHYSICS, BIOLOGY AND MEDICINE, CHAPMAN AND HALL, LONDON, GB, vol. 24, no. 6, 14 juillet 2011 (2011-07-14), pages 315-322, XP019980706, ISSN: 1352-8661, DOI: 10.1007/S10334-011-0270-Y**
• **VALENTINA HARTWIG ET AL: "A novel tool for estimation of magnetic resonance occupational exposure to spatially varying magnetic fields", MAGNETIC RESONANCE MATERIALS IN PHYSICS, BIOLOGY AND MEDICINE, CHAPMAN AND HALL, LONDON, GB, vol. 24, no. 6, 4 septembre 2011 (2011-09-04), pages 323-330, XP019980707, ISSN: 1352-8661, DOI: 10.1007/S10334-011-0279-2**

- SAMI KÃ NNÃ LÃ ET AL: "Occupational exposure measurements of static and pulsed gradient magnetic fields in the vicinity of MRI scanners; Exposure measurements in the vicinity of MRI scanners", PHYSICS IN MEDICINE AND BIOLOGY, TAYLOR AND FRANCIS LTD. LONDON, GB, vol. 54, no. 7, 7 avril 2009 (2009-04-07), pages 2243-2257, XP020149920, ISSN: 0031-9155, DOI: 10.1088/0031-9155/54/7/026
- GLOVER P M ET AL: "Measurement of electric fields induced in a human subject due to natural movements in static magnetic fields or exposure to alternating magnetic field gradients; Measurement of induced electric fields in human subjects", PHYSICS IN MEDICINE AND BIOLOGY, TAYLOR AND FRANCIS LTD. LONDON, GB, vol. 53, no. 2, 21 janvier 2008 (2008-01-21), pages 361-373, XP020127330, ISSN: 0031-9155
- FUENTES M A ET AL: "Analysis and Measurements of Magnetic Field Exposures for Healthcare Workers in Selected null MR Environments", IEEE TRANSACTIONS ON BIOMEDICAL ENGINEERING, IEEE SERVICE CENTER, PISCATAWAY, NJ, USA, vol. 55, no. 4, 1 avril 2008 (2008-04-01), pages 1355-1364, XP011342676, ISSN: 0018-9294, DOI: 10.1109/TBME.2007.913410
- LIU F ET AL: "Calculation of electric fields induced by body and head motion in high-field MRI", JOURNAL OF MAGNETIC RESONANCE, ACADEMIC PRESS, ORLANDO, FL, US, vol. 161, no. 1, 1 mars 2003 (2003-03-01), pages 99-107, XP004415781, ISSN: 1090-7807, DOI: 10.1016/S1090-7807(02)00180-5
- FORMICA DOMENICO ET AL: "Biological effects of exposure to magnetic resonance imaging: an overview", BIOMEDICAL ENGINEERING ONLINE, BIOMED CENTRAL LTD, LONDON, GB, vol. 3, no. 1, 22 avril 2004 (2004-04-22), page 11, XP021007724, ISSN: 1475-925X, DOI: 10.1186/1475-925X-3-11

**Description**

**Domaine technique**

La présente invention concerne un appareil de surveillance destiné à être utilisé en présence d'un champ magnétique.

La présente invention concerne également un procédé mis en oeuvre dans l'appareil selon l'invention.

Le domaine de l'invention est plus particulièrement mais de manière non limitative celui des environnements IRM (Imagerie par Résonance Magnétique) et RMN (Résonance Magnétique Nucléaire).

**Etat de la technique antérieure**

Un appareil émettant un champ magnétique, en particulier un appareil IRM (appareil d'Imagerie par Résonance Magnétique), un appareil utilisant la technologie RMN, un four à microondes, émet un fort champ magnétique. Il s'agit généralement d'un champ magnétique basse fréquence (fréquences inférieures à 30 GHz, en particulier inférieures à 1 GHz dans le cas particulier des environnements IRM)

Ce champ magnétique comprend :

- un champ magnétique dit statique, c'est-à-dire constant dans le temps. Celui-ci peut être variable spatialement et provoquer, chez un opérateur ou une machine en mouvement dans ce champ statique un courant induit. Un courant induit traversant un être humain provoque chez lui des troubles tels que des nausées, des maux de tête, des phosphènes (hallucinations visuelles), un goût métallique dans la bouche, etc. ; et/ou
- un champ magnétique dit variable, c'est-à-dire variable dans le temps. Celui-ci peut provoquer chez l'homme des stimulations nerveuses, du fait du courant induit engendré. Le champ magnétique variable créé un courant induit traversant un opérateur ou une machine immobile dans ce champ variable. Le champ magnétique variable créé également un courant induit traversant un opérateur ou une machine se trouvant dans ce champ variable.

En outre, un champ magnétique est également susceptible de détériorer une machine, notamment une machine abritant un circuit électrique.

On connaît à ce jour des appareils de surveillance dans un environnement magnétique mettant en oeuvre uniquement un capteur de mesure d'un champ magnétique. Un tel capteur peut par exemple comprendre un capteur à effet Hall, et peut être agencé pour mesurer un champ magnétique dans chacune des trois directions de l'espace. Un tel appareil est par exemple divulgué dans l'article de Karpowicz, "Assessment of induced currents hazards among health care workers operating magnetic resonance scanners - towards new standardization approach", APPLIED SCIENCES IN BIOMEDICAL AND COMMUNICATION TECHNOLOGIES, 2009. Un inconvénient de ces appareils est qu'ils ne permettent de prendre en compte qu'une partie seulement des courants induits par le champ magnétique mesuré.

Un but de la présente invention est de proposer un appareil de surveillance qui soit mieux adapté à la surveillance d'opérateurs et machines évoluant dans un environnement magnétique.

Un autre but de la présente invention est de proposer un procédé mis en oeuvre dans un appareil selon l'invention.

**Exposé de l'invention**

Cet objectif est atteint avec un appareil de surveillance de conditions d'exposition auxquelles est soumis un opérateur ou une machine situé dans un environnement magnétique, tel que défini par la revendication 1, comprenant un dispositif portatif agencé pour être embarqué sur l'opérateur ou la machine, ledit dispositif portatif comprenant des modules portatifs parmi lesquels un module portatif de mesure, à plusieurs instants t connus, d'une donnée indicative comprenant les trois composantes d'un vecteur de champ magnétique.

Le dispositif portatif comprend en outre un module portatif de mesure d'une donnée indicative permettant de déterminer les trois composantes d'un vecteur de vitesse de déplacement aux instants t connus ; et l'appareil de surveillance comprend des moyens de calcul comprenant des moyens pour calculer une estimation d'un courant induit traversant l'opérateur ou la machine, à partir des vecteurs de champ magnétique et de vitesse de déplacement aux instants t connus. Comme expliqué plus loin, les moyens de calcul selon l'invention sont avantageusement agencés pour calculer une estimation d'un courant induit, en utilisant un calcul de déplacement relatif de l'opérateur ou la machine entre deux instants t connus. La donnée du déplacement relatif est obtenue à partir de la mesure de la vitesse de déplacement. On peut ainsi considérer que les moyens de calcul selon l'invention mettent avantageusement en oeuvre un calcul des trois composantes d'un vecteur position aux instants t connus.

Le calcul du courant induit peut être mis en oeuvre à partir des équations données dans la suite, mais qui ne sont données qu'à titre d'exemple (notamment, on pourrait envisager divers calculs d'approximation d'une dérivée partielle).

Avantageusement, les mesures de vitesse et de champ magnétique se font aux mêmes instants t.

Dans tout le texte, le terme « opérateur » désigne de préférence un être humain, éventuellement un animal.

Par « portatif », on entend embarqué sur l'opérateur respectivement la machine.

Un environnement magnétique selon l'invention peut être créé par exemple par la proximité d'un appareil IRM, d'un appareil utilisant la technologie RMN, d'un four à microonde tel que ceux utilisés dans l'industrie sidérurgique, etc.

Le champ magnétique mesuré est celui auquel est soumis l'opérateur ou la machine. C'est le champ magnétique mesuré à l'endroit où le dispositif portatif est placé. Il se décompose généralement en un champ magnétique statique et un champ magnétique variable. Le champ magnétique est mesuré de préférence grâce à un ensemble de trois capteurs mesurant chacun le champ magnétique selon l'une des dimensions de l'espace. On peut ainsi exprimer le champ magnétique comme un vecteur.

Le champ magnétique étant mesuré à plusieurs instants t connus, on dispose de mesures de temps, formées par la connaissance des durées entre deux mesures de champ magnétique consécutives. On peut considérer que le calcul d'une estimation d'un courant induit prend en compte des mesures de temps.

La vitesse de déplacement est la vitesse de déplacement du dispositif portatif, et correspond à la vitesse de déplacement de l'opérateur ou la machine. En pratique, on pourra mesurer une accélération (donnée indicative permettant de déterminer une vitesse de déplacement), puis en déduire une vitesse de déplacement, l'accélération étant la dérivée par rapport au temps de la vitesse. Cette accélération peut également être mesurée selon trois dimensions de l'espace.

Le courant induit est le courant induit traversant l'opérateur ou la machine. Le courant induit selon l'invention désigne non seulement le courant induit par un champ magnétique variable, mais également tout courant induit par un déplacement dans un champ magnétique statique comme variable. C'est la connaissance d'une vitesse de déplacement qui permet le calcul d'une estimation d'un courant induit, de façon bien plus précise que dans l'art antérieur puisque l'ensemble des contributions d'un champ magnétique donné est pris en compte (voir formule (02) plus loin).

Grâce à la connaissance complète du courant induit traversant l'opérateur ou la machine, on peut donc avoir une meilleure évaluation des risques sanitaires respectivement techniques encourus dans un environnement magnétique, en particulier à proximité d'un appareil utilisant la technologie de résonance magnétique, tel qu'un appareil IRM.

On obtient ainsi un appareil de surveillance particulièrement adapté à la surveillance d'opérateurs ou machines évoluant dans un environnement magnétique, notamment à proximité d'un appareil utilisant la technologie de résonance magnétique, tel qu'un appareil IRM.

En outre, le fait que les mesures permettant de déterminer une vitesse de déplacement et d'une variation d'un champ magnétique au cours du temps soient effectuées grâce à un dispositif portatif permet une utilisation particulièrement pratique. Où que se trouve l'opérateur ou la machine, les valeurs relatives aux conditions auxquelles il respectivement elle est soumis(e) peuvent être relevées avec précision et en temps réel. L'aspect portatif permet une surveillance au jour le jour et sur le long terme.

L'appareil de surveillance selon l'invention peut ne mettre en oeuvre que des composés peu onéreux.

En outre, il peut ne mettre en oeuvre que peu d'éléments et des éléments ne nécessitant pas de réglages lourds ce qui rend son utilisation particulièrement simple.

Le dispositif portatif comprend avantageusement des moyens d'alimentation autonomes tels qu'une batterie. Il peut ainsi être utilisé sans liaison filaire avec une alimentation externe, qui viendrait entraver un mouvement ou limiter une zone de déplacement.

Une utilisation particulièrement avantageuse de l'appareil de surveillance selon l'invention concerne la surveillance de travailleurs médicaux (radiologues, anesthésistes, chirurgiens, pédiatres, chercheurs, etc), contraints d'évoluer à proximité d'un appareil IRM ou RMN, et qui pourraient être soumis à des conditions susceptibles de causer des dommages sur leur santé.

Une autre utilisation particulièrement avantageuse de l'appareil de surveillance selon l'invention concerne la surveillance de patients soumis à un examen médical, par exemple des patients se trouvant à l'intérieur d'un appareil IRM.

Une autre utilisation particulièrement avantageuse de l'appareil de surveillance selon l'invention concerne la surveillance d'une machine en vue d'établir si une garantie s'applique ou non en fonction de conditions auxquelles la machine a été exposée.

De préférence, les modules portatifs de mesure sont agencés pour réaliser des mesures en continu. On peut également prévoir que ces mesures soient ponctuelles et répétées au cours du temps. En pratique, les modules portatifs de mesure mettent généralement en oeuvre des mesures numériques avec un échantillonnage dans le temps.

Le module portatif de mesure d'une variation de champ magnétique peut être agencé pour mesurer le champ magnétique dans trois directions définissant l'espace à trois dimensions.

Le module portatif de mesure d'une donnée indicative permettant de déterminer une vitesse de déplacement peut comprendre un accéléromètre.

La connaissance de la vitesse de l'opérateur permet, combinée à la mesure à plusieurs instants t connus du champ magnétique auquel l'opérateur ou la machine est soumis(e), de retrouver une estimation de l'intégralité du courant induit traversant l'opérateur ou la machine.

Le courant induit peut être calculé en utilisant la loi de Faraday. La loi de Faraday dit que la force électromotrice induite dans un bobinage fermé (ici c'est un corps humain ou animal, ou une machine) placé dans un champ magnétique est proportionnelle à la variation au cours du temps du flux du champ magnétique qui entre dans le circuit.

La formule de calcul d'un courant induit classiquement utilisée est la suivante :

$$\vec{J} = A\sigma R\left(\frac{d\vec{B}}{dt}\right), \qquad (01)$$

où $\vec{J}$ est la densité de courant à calculer (vecteur),

$R$ est le rayon en unité de longueur de la boucle de courant induit : par exemple, $R$ vaut 0,64 mètres dans le thorax et 7 centimètres dans la tête ;

$\sigma$ est la conductivité du tissu humain (par exemple 0,2 S/m mais on peut prévoir un modèle précis en fonction des types de tissus) ;

$A$ est une constante prenant typiquement la valeur 0,5 ; $\dfrac{d\vec{B}}{dt}$ est la variation en fonction en temps du champ magnétique statique et variable (vecteur). B est une fonction du temps et de l'espace.

Le calcul du courant induit nécessite de connaître un modèle de la conductivité de l'objet étudié, afin de déterminer la valeur de $\sigma$. Des modèles de conductivité, par exemple du corps humain, sont bien connus dans la littérature (voir par exemple ICRP. Basic anatomical and physiological data for use in radiological protection: référence values. Publication 89. Stockholm: ICRP; 2002. p. 84). Ces modèles n'étant que des approximations de la réalité, on obtiendra en pratique des estimations de courant induit.

Cette formule, prise telle qu'elle, permet d'estimer uniquement des courants induits par un champ magnétique variable à l'endroit où les mesures de champ magnétiques ont été prises, c'est-à-dire à l'endroit où le dispositif est placé. A partir des mesures d'un seul point, on extrapole une estimation d'exposition aux champs magnétiques et indirectement aux courants induits sur tout le corps de l'opérateur ou la machine.

On peut utiliser d'autres formules connues, qui dans tous les cas mettent en oeuvre un calcul de $\dfrac{d\vec{B}}{dt}$.

Une idée à la base de l'invention consiste à déterminer également la vitesse de déplacement d'un opérateur respectivement d'une machine étudié(e), en plaçant un module portatif de mesure d'une donnée indicative permettant de déterminer une vitesse (par exemple un accéléromètre) directement sur celui-ci respectivement celle-ci.

On peut alors estimer également le courant induit par un déplacement dans un champ statique, grâce à la décomposition suivante :

$$\left(\frac{d\vec{B}(\vec{r},t)}{dt}\right) = \left(\frac{\partial\vec{B}(\vec{r},t)}{\partial t}\right) + \left(\frac{\partial\vec{B}(\vec{r},t)}{\partial\vec{r}}\right)\left(\frac{d\vec{r}}{dt}\right) = \left(\frac{\partial\vec{B}(\vec{r},t)}{\partial t}\right) + \left(\frac{\partial\vec{B}(\vec{r},t)}{\partial\vec{r}}\right)\vec{v},$$

où $\vec{v}$ est la vitesse de déplacement de l'objet (l'opérateur respectivement la machine),

$\vec{r} = (r_x.\vec{i}, r_y.\vec{j}, r_z.\vec{k})$ est le vecteur de déplacement dans un espace à trois dimensions, avec $\vec{i},\vec{j},\vec{k}$ des vecteurs unitaires dans les trois dimensions définissant cet espace,

$\dfrac{\partial\vec{B}(\vec{r},t)}{\partial t}$ est la variation du champ magnétique en fonction du temps ;

$\dfrac{\partial\vec{B}(\vec{r},t)}{\partial\vec{r}}$ est la variation du champ magnétique en fonction de la position de l'opérateur respectivement la machine étudié(e).

Le module portatif de mesure d'un champ magnétique est de préférence un capteur selon trois dimensions.

L'invention est ainsi bien plus complète que les appareils de l'art antérieur.

On obtient grâce à l'invention un courant induit total :

$$\vec{J} = A\sigma R\left[\left(\frac{\partial \vec{B}(\vec{r},t)}{\partial t}\right) + \left(\frac{\partial \vec{B}(\vec{r},t)}{\partial \vec{r}}\right)\vec{v}\right] = \vec{J}_1 + \vec{J}_2 \qquad (02)$$

où

$\vec{J}_1$ est le courant induit (vecteur) par le champ magnétique variable ; et

$\vec{J}_2$ est le courant induit (vecteur) par le champ magnétique statique et le champ magnétique variable, du fait du déplacement de l'opérateur ou de la machine.

La mesure d'une donnée indicative permettant de déterminer une vitesse, effectuée par un dispositif embarqué sur l'opérateur, permet une utilisation immédiate de cette décomposition.

La mesure d'une donnée indicative permettant de déterminer une vitesse, effectuée par un dispositif embarqué sur l'opérateur, permet une utilisation permanente de cette décomposition, la donnée de la vitesse étant disponible où que ce trouve l'opérateur ou la machine.

Les modules portatifs peuvent comprendre en outre un module portatif de mesure d'une donnée indicative comprenant une énergie radiofréquence.

Les caractéristiques du module portatif de mesure d'une énergie radiofréquence peuvent être dictées par une gamme de radiofréquences que l'on souhaite détecter. En particulier, ledit module peut comprendre une antenne, dont la longueur est déterminée par la gamme de radiofréquences que l'on souhaite détecter.

La longueur de l'antenne est déterminée de préférence par la valeur du champ magnétique statique auquel est soumis l'opérateur ou la machine. Par exemple, dans le cas d'un appareil IRM émettant un champ magnétique statique de 1,5 Tesla, la longueur de l'antenne est avantageusement accordée à une radiofréquence de 64 MHz.

La gamme de radiofréquences émise dépend du champ magnétique émis, ces deux paramètres étant liés par l'équation de Larmor pour avoir le phénomène de résonance.

On peut prévoir un asservissement entre une mesure d'un champ statique auquel est soumis l'opérateur ou la machine, et la longueur de l'antenne, cette dernière pouvant être de longueur variable.

On peut en particulier mesurer une énergie radiofréquence à laquelle est soumis l'opérateur ou la machine, puis obtenir l'énergie radiofréquence absorbée par l'opérateur ou la machine à partir d'un coefficient d'absorption.

Par exemple, un appareil utilisant la technologie de résonance magnétique tel qu'un appareil IRM ou RMN, émet un rayonnement radiofréquence qui peut être nuisible à la santé d'un opérateur humain respectivement à l'intégrité d'une machine électrique.

On peut alors disposer d'un appareil de surveillance prenant également en compte l'exposition aux radiofréquences.

Les modules portatifs peuvent comprendre en outre un module portatif de mesure d'une donnée indicative comprenant un niveau sonore.

Par exemple, un appareil utilisant la technologie de résonance magnétique tel qu'un appareil IRM, émet en effet des bruits acoustiques d'une puissance pouvant atteindre 110 dB acoustiques et qui peuvent être nuisibles, notamment à la santé d'un opérateur.

On peut alors disposer d'un procédé de surveillance prenant également en compte l'exposition au bruit.

L'appareil selon l'invention peut comprendre des moyens de calcul comprenant des moyens pour calculer un indicateur global d'exposition prenant en compte au moins une donnée indicative et pour activer des moyens d'émission d'un signal d'alerte lorsque l'indicateur global d'exposition dépasse un seuil prédéterminé.

Dans une variante préférée de l'invention, l'indicateur global d'exposition est formé par l'estimation du courant induit.

De préférence, l'appareil selon l'invention comprend des moyens de calcul comprenant des moyens pour calculer un indicateur global d'exposition prenant en compte chaque donnée indicative et pour activer des moyens d'émission d'un signal d'alerte lorsque l'indicateur global d'exposition dépasse un seuil prédéterminé.

On obtient ainsi un indicateur représentatif d'un risque global pour la santé, que ce risque provienne d'une exposition à des nuisances sonores, à une énergie radiofréquence, et/ou d'un courant induit traversant l'opérateur ou la machine.

On a alors un appareil de surveillance unique et permettant de rendre compte d'un risque global lié à plusieurs paramètres.

En outre, cet appareil de surveillance permet d'émettre un signal d'alerte si des conditions d'exposition dépassent un seuil prédéterminé pour l'indicateur global d'exposition.

Des mesures peuvent alors être prises pour éviter toute possible mise en danger de l'opérateur ou la machine, par exemple en éloignant l'opérateur ou la machine de la source de champ magnétique, en particulier d'un appareil utilisant la technologie de résonance magnétique.

Le seuil prédéterminé pour l'indicateur global d'exposition peut être établi en fonction de statistiques.

Le dispositif portatif peut comprendre des moyens d'alerte agencés pour signaler une sensation de malaise (en particulier une sensation de malaise d'un opérateur) lorsqu'ils sont activés, et l'appareil selon l'invention peut comprendre des moyens de calcul comprenant des moyens pour prendre en compte une donnée provenant de ces moyens d'alerte afin de déterminer un seuil d'exposition.

Ledit seuil d'exposition peut être :

- un seuil global relatif à chaque donnée indicative mesurée ou
- un seuil global relatif à plusieurs données indicatives mesurées ou
- un seuil relatif au courant induit seul ou à une donnée indicative seule.

Le seuil d'exposition peut correspondre au seuil prédéterminé pour l'indicateur global d'exposition.

Le seuil d'exposition peut être relatif à une limite au-delà de laquelle un opérateur ressent un malaise, cette sensation de malaise pouvant être due au courant induit, ou à une autre des données indicatives selon l'invention.

On peut ainsi mettre en oeuvre une personnalisation d'un niveau alerte. Cette caractéristique est particulièrement adaptée à l'utilisation de l'appareil selon l'invention par un opérateur humain, et permet d'adapter à la physiologie particulière de chaque opérateur un seuil d'émission d'un signal d'alerte.

Le malaise peut consister en des nausées, un goût métallique dans la bouche, un sifflement d'oreille, une stimulation cardiaque, ou tout autre symptôme prédéterminé.

On peut prévoir une graduation des sensations de malaise, de façon à obtenir un jeu de plusieurs seuils d'exposition allant d'un seuil dit de prévoyance (indiquant que des mesures doivent être prises à moyen terme, par exemple dans l'année), à un seuil dit extrême (indiquant que des mesures doivent être prises immédiatement).

Un jeu de plusieurs seuils d'exposition peut correspondre à un jeu de plusieurs seuils prédéterminés pour l'indicateur global d'exposition. On peut ainsi prévoir un jeu de plusieurs signaux d'alerte en fonction du seuil prédéterminé qui est dépassé.

Avantageusement, au moins une partie des moyens de calcul est placée dans le dispositif portatif.

On a alors un appareil de surveillance qui peut être d'un seul tenant.

Les calculs réalisés par lesdits moyens de calcul peuvent alors être réalisés sans besoin d'une liaison par exemple non-filaire avec un calculateur externe.

Les modules portatifs peuvent comprendre en outre un module portatif de mesure d'une donnée indicative comprenant une position relative de l'opérateur ou de la machine (relativement à un point de référence ou un référentiel donné).

On utilise par exemple une unité de mesure inertielle (on parle généralement d' « IMU », pour l'anglais « inertial measurement unit »), comprenant un gyroscope et un accéléromètre. L'accéléromètre de l'IMU peut alors être confondu avec un accéléromètre formant le module portatif de mesure d'une donnée indicative permettant de déterminer une vitesse de déplacement.

L'appareil de surveillance selon l'invention peut comprendre des moyens de calcul comprenant des moyens pour réaliser une cartographie d'une donnée indicative et/ou d'un indicateur global d'exposition.

On peut alors identifier des emplacements plus ou moins dangereux dans en environnement magnétique, notamment à proximité d'un appareil utilisant la technologie de résonance magnétique.

On peut également utiliser cette cartographie pour réaliser des moyens de guidage visuel à proximité d'une source de champ magnétique telle qu'un appareil utilisant la technologie de résonance magnétique, afin de :

- mettre en évidence un trajet recommandé à proximité de la source de champ magnétique ; et/ou
- mettre en évidence au moins une zone à proximité de la source de champ magnétique, et à l'intérieur de laquelle la vitesse de l'opérateur ou de la machine doit être réduite.

Au moins une partie des moyens de calcul peut être placée dans une base non embarquée. Cette base forme alors, avec le dispositif portatif, l'appareil de surveillance selon l'invention.

De façon avantageuse, on pourra prévoir une communication, notamment bidirectionnelle entre le dispositif portatif et la base :

- une communication non filaire (par exemple périodiquement tous les quarts d'heure) ; et/ou
- une communication par contact physique, par exemple en reposant après chaque utilisation le dispositif portatif sur une interface adaptée de la base.

En outre, la base peut stocker des données indicatives mesurées, des seuils prédéterminés pour l'indicateur global d'exposition, des profils utilisateurs, des seuils d'expositions, etc. Ces informations stockées permettent notamment d'effectuer des études sanitaires sur le long terme en fonction des données stockées et du devenir des opérateurs ou des machines exposés.

On peut également prévoir que la position de la base soit déterminée et éventuellement fixe. La base peut ainsi former un point de référence utilisé pour mesurer une position relative de l'utilisateur.

On dispose grâce à l'invention d'un appareil de surveillance particulièrement simple mais offrant de nombreuses fonctionnalités.

L'invention concerne également un système comprenant l'appareil de surveillance selon l'invention et un appareil utilisant la technologie de résonance magnétique.

L'invention concerne également un procédé de surveillance comprenant une étape de mesure répétée à plusieurs instants t connus, d'une donnée indicative comprenant les trois composantes d'un vecteur de champ magnétique auquel est soumis un opérateur ou une machine, tel que défini par la revendication 8. Ledit procédé est mis en oeuvre pour la surveillance de conditions d'exposition auxquelles est soumis l'opérateur ou la machine lorsqu'il respectivement elle se trouve dans un environnement magnétique, et il comprend les étapes suivantes :

- détermination, en utilisant un module portatif pour déterminer une vitesse, porté par l'opérateur ou la machine, des trois composantes d'un vecteur de vitesse de déplacement de l'opérateur ou de la machine aux instants t connus; puis
- en utilisant les vecteurs de champ magnétique et de vitesse de déplacement aux instants t connus, calcul d'une estimation d'un courant induit traversant l'opérateur ou la machine.

Comme expliqué dans le texte, l'étape de calcul d'une estimation d'un courant induit met avantageusement en oeuvre un calcul d'une estimation de déplacement relatif de l'opérateur ou la machine entre deux instants t connus. La donnée du déplacement relatif est obtenue à partir de la vitesse de déplacement. On peut ainsi considérer que l'étape de calcul selon l'invention met avantageusement en oeuvre un calcul des trois composantes d'un vecteur position aux instants t connus.

Le calcul du courant induit peut être mis en oeuvre à partir des équations données dans le texte, mais qui ne sont données qu'à titre d'exemple (notamment, on pourrait envisager divers calculs d'approximation d'une dérivée partielle).

L'étape de mesure répétée à plusieurs instants t connus d'une donnée indicative comprenant un champ magnétique, est mise en oeuvre en utilisant un module portatif de mesure de champ magnétique porté par l'opérateur ou la machine.

Le module portatif pour déterminer une vitesse est formé par un module portatif de mesure d'une donnée indicative permettant de déterminer une vitesse de déplacement.

On peut considérer que le calcul d'une estimation d'un courant induit prend en compte des mesures de temps.

L'ensemble des utilisations avantageuses, effets et avantages énoncés à propos de l'appareil de surveillance selon l'invention concerne également le procédé selon l'invention.

On peut mesurer en outre une donnée indicative comprenant une énergie radiofréquence à laquelle est soumis l'opérateur ou la machine. On peut alors estimer une énergie radiofréquence absorbée par l'opérateur ou la machine.

L'étape de mesure d'une donnée indicative comprenant une énergie radiofréquence à laquelle est soumis l'opérateur ou la machine peut être mise en oeuvre en utilisant un module portatif de mesure d'énergie radiofréquence porté par l'opérateur ou la machine.

On peut mesurer en outre une donnée indicative comprenant un niveau sonore auquel est soumis l'opérateur ou la machine.

L'étape de mesure d'une donnée indicative comprenant un niveau sonore auquel est soumis l'opérateur ou la machine peut être mise en oeuvre en utilisant un module portatif de mesure de niveau sonore porté par l'opérateur ou la machine.

De préférence, chaque donnée indicative est prise en compte pour calculer un indicateur global d'exposition.

Un signal d'alerte peut être émis lorsque l'indicateur global d'exposition dépasse un seuil prédéterminé.

Le signal d'alerte peut être émis depuis un dispositif portatif embarqué sur l'opérateur ou la machine.

Avantageusement, le procédé selon l'invention comprend les étapes suivantes :

- l'opérateur signale, via des moyens d'alerte, une sensation de malaise ; puis
- on en déduit un seuil d'exposition.

Les détails sur le seuil d'exposition développés précédemment s'appliquent également dans le cadre du procédé selon l'invention.

Lesdits moyens d'alerte peuvent être situés dans un dispositif portatif embarqué sur l'opérateur.

On peut mesurer en outre une position relative de l'opérateur ou de la machine (relativement à un point de référence ou un référentiel donné), et réaliser une cartographie d'une donnée indicative mesurée.

L'étape de mesure d'une donnée indicative comprenant une position relative de l'opérateur ou de la machine peut être mise en oeuvre en utilisant un module portatif de mesure de position porté par l'opérateur ou la machine.

Au moins une partie des étapes précitées de calcul, déduction, réalisation d'une cartographie peut être mise en oeuvre par des moyens de calcul distants situés dans une base, et en communication avec un dispositif portatif embarqué sur l'opérateur ou la machine et comprenant les autres éléments nécessaires à la mise en oeuvre de l'invention. Ladite communication peut être en temps réel ou en temps différé.

Les moyens de calculs peuvent également être embarqués sur l'opérateur ou la machine.

La position relative peut être mesurée par rapport à un point de référence qui peut être formé par ladite base.

Le procédé selon l'invention peut être mis en oeuvre à proximité d'une source de champ magnétique telle qu'un appareil utilisant la technologie de résonance magnétique, et on peut réaliser des moyens de guidage visuels à proximité de la source de champ magnétique, de façon à :

- mettre en évidence un trajet recommandé à proximité de la source de champ magnétique ; et/ou
- mettre en évidence au moins une zone à proximité de la source de champ magnétique, et à l'intérieur de laquelle la vitesse de l'opérateur ou machine doit être réduite.

On peut ainsi guider un opérateur humain pour lui permettre de minimiser les risques pour sa santé lorsqu'il évolue à proximité d'une source de champ magnétique telle qu'un appareil utilisant la technologie de résonance magnétique.

Le procédé selon l'invention est avantageusement mis en oeuvre dans un appareil de surveillance selon l'invention.

Les avantages, effets techniques et précisions énoncés à propos de l'appareil selon l'invention concernent également le procédé selon l'invention.

**Description des figures et modes de réalisation**

D'autres avantages et particularités de l'invention apparaîtront à la lecture de la description détaillée de mises en oeuvre et de modes de réalisation nullement limitatifs, et des dessins annexés suivants :

- la figure 1 illustre un premier mode de réalisation d'un appareil de surveillance selon l'invention,
- la figure 2 illustre un deuxième mode de réalisation d'un appareil de surveillance selon l'invention,
- la figure 3 illustre un troisième mode de réalisation d'un appareil de surveillance selon l'invention,
- la figure 4 illustre un quatrième mode de réalisation d'un appareil de surveillance selon l'invention, et
- la figure 5 illustre un aspect du procédé de surveillance selon l'invention.

La description du fonctionnement de l'appareil de surveillance selon l'invention permettra également d'illustrer le procédé de surveillance selon l'invention.

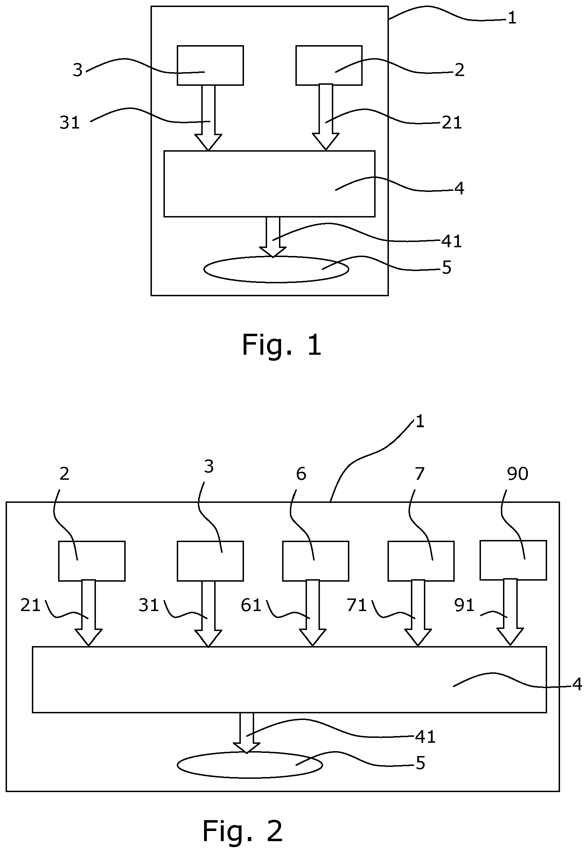

On va tout d'abord décrire, en référence à la figure 1, un premier mode de réalisation d'un appareil de surveillance 1 selon l'invention.

Un tel appareil est destiné à être utilisé pour surveiller des conditions d'exposition à proximité d'une source de champ magnétique, c'est-à-dire généralement dans un rayon de quelques mètres autour de cette source.

Dans toute la suite, on prendra comme exemple de source de champ magnétique un appareil IRM, mais ce choix n'est nullement limitatif.

On peut également envisager d'utiliser l'appareil selon l'invention à proximité d'un appareil RMN, ou de toute autre source de rayonnement magnétique.

L'appareil peut être utilisé par exemple par des travailleurs médicaux travaillant en environnement IRM, en particulier pour s'assurer que des expositions auxquels ils sont soumis rentrent bien dans le cadre de ce qui est imposé par la Directive Européenne 2004/40/EC réglementant l'exposition des travailleurs pour un spectre de fréquence allant de 0Hz à 300 GHz.

En effet, les études menées montrent que dans le cadre d'examens IRM, les courants induits supportés par les opérateurs humains peuvent être bien supérieurs aux seuils imposés par la Directive, d'où l'importance de connaître en temps réel ces courants induits pour adapter son comportement. Par exemple, un travailleur se déplaçant dans un champ magnétique statique à proximité d'un appareil IRM, lors d'une opération de maintenance, d'entretien, ou pour l'installation d'un patient, peut être soumis à des courants induits dix fois supérieurs aux seuils imposés par la Directive. De même, un travailleur se trouvant à l'entrée d'un appareil IRM pendant l'acquisition d'une image peut être soumis à des courants induits cinquante fois supérieurs aux seuils imposés par la Directive.

L'appareil peut aussi être utilisé pour mémoriser des conditions d'exposition d'une machine par exemple électronique afin de vérifier par exemple si l'utilisation de la machine se fait dans des conditions couvertes par une garantie ou non.

Dans toute la suite, on gardera l'exemple de la surveillance des conditions d'exposition d'un opérateur 200.

L'appareil 1 selon l'invention comprend :

- un module portatif 2 de mesure d'un champ magnétique, à différents instants t connus ;
- un module portatif 3 pour déterminer une vitesse de déplacement à partir d'une mesure d'accélération ; et
- des moyens de calcul 4 pour calculer un courant induit à partir desdites valeurs de champ magnétique et de vitesse de déplacement.

Les instants t des mesures de champ magnétique et d'accélération sont également exploités.

Le module portatif 2 de mesure d'un champ magnétique à différents instants t connus est formé par un capteur à effet Hall. Ce capteur à effet Hall permet de mesurer des champs magnétiques statiques et variables. Les champs magnétiques mesurés peuvent aller par exemple jusqu'à 3 Tesla. On peut également prévoir de mesurer des champs bien plus intenses (par exemple 10 Tesla, en fonction de l'appareil IRM se trouvant dans l'environnement étudié). On mesure le champ magnétique séparément selon trois directions de l'espace.

Le module portatif 3 pour déterminer une vitesse de déplacement est formé par un accéléromètre qui de préférence peut mesurer des accélérations séparément selon trois directions de l'espace.

Les moyens de calcul 4 sont formés par exemple par un microcontrôleur ou un microprocesseur.

Au moins une partie de l'appareil 1 selon l'invention, comprenant notamment les éléments identifiés comme portatifs, est embarquée sur l'opérateur.

Les différents modules portatifs, permettant d'effectuer des mesures relatives à l'opérateur 200, sont tous embarqués sur l'opérateur.

Les moyens de calcul 4, par contre, peuvent être distants.

Le capteur à effet Hall 2 envoie ses mesures vers les moyens de calcul 4 (l'envoi étant symbolisé par la flèche 21).

L'accéléromètre 3 mesure une accélération de l'opérateur 200, ce qui permet d'obtenir une connaissance de la vitesse de déplacement grâce aux calculs mise en oeuvre par les moyens de calcul 4.

Il envoie ses mesures vers les moyens de calcul 4 (l'envoi étant symbolisé par la flèche 31).

Les moyens de calcul 4, à partir des mesures reçues, peuvent calculer une estimation du courant induit traversant l'opérateur, selon la formule :

$$\vec{J} = 0,5\sigma R \left[ \left( \frac{\partial \vec{B}(\vec{r},t)}{\partial t} \right) + \left( \frac{\partial \vec{B}(\vec{r},t)}{\partial \vec{r}} \right) \vec{v} \right],$$

où

$\vec{J}$ est la densité de courant à estimer (vecteur),

$R$ est une constante prenant des valeurs typiquement comprises entre 0,1 (valeur pour la tête) et 0,3 (valeur pour le corps),

$\sigma$ est la conductivité du tissu humain (par exemple 0,2 S/m mais on peut prévoir un modèle précis en fonction des types de tissus),

$\vec{v}$ est la vitesse de déplacement de l'opérateur (vecteur),

$\vec{r} = (r_x.\vec{i}, r_y.\vec{j}, r_z.\vec{k})$ est le vecteur de déplacement dans un espace à trois dimensions, avec $\vec{i},\vec{j},\vec{k}$ est vecteurs unitaires dans les trois dimensions définissant cet espace,

$\frac{\partial \vec{B}(\vec{r},t)}{\partial t}$ est la variation du champ magnétique en fonction du temps (vecteur);

$\frac{\partial \vec{B}(\vec{r},t)}{\partial \vec{r}}$ est la variation du champ magnétique en fonction de la position de l'opérateur (vecteur).

Le capteur à effet Hall 2 mesure le champ magnétique $\vec{B}$ incluant le champ statique et le champ variable.

A un instant *t1* on mesure un champ magnétique $\vec{B}_1$.

A un instant *t2* on mesure un champ magnétique $\vec{B}_2$.

Entre les instants *t1* et *t2* on mesure une accélération $\vec{a}(t)$.

A partir de l'accélération, on peut calculer le déplacement relatif entre les instants *t1* et *t2* :

$$\vec{r}(T) = \int_0^T \left[ \int_0^t \vec{a}(t)dt \right] dt \text{, avec } T = t2\text{-}t1, \; t2\text{>}t1.$$

A partir de l'accélération, on obtient également la vitesse de déplacement entre les instants *t1* et *t2* :

$$\vec{v}(t) = \int_0^t \vec{a}(t)dt.$$

Ensuite, on utilisant l'approximation selon laquelle : $\dfrac{df(x)}{dx} \approx \dfrac{f(x + \Delta x) - f(x)}{\Delta x}$, $\Delta x \to 0$, on obtient :

$$\frac{\partial \vec{B}(\vec{r},t)}{\partial t} \approx \frac{\vec{B}_2 - \vec{B}_1}{t2 - t1} \qquad\qquad (03),$$

$$\frac{\partial \vec{B}(\vec{r},t)}{\partial \vec{r}} \approx \frac{\vec{B}_2 - \vec{B}_1}{\vec{r}(T)} \qquad\qquad (04)$$

Les erreurs d'approximation sont d'autant plus réduites que *T* est petit, par exemple *T* est compris entre 1 et 100 microsecondes.

En pratique, les mesures de champ magnétique et d'accélération sont des mesures numériques : elles sont donc échantillonnées dans le temps selon une fréquence d'échantillonnage déterminée et suffisante (de l'ordre du kHz) pour mettre en oeuvre les approximations (03) et (04). Le courant induit calculé prend en compte le courant induit causé par les variations d'un champ magnétique variable, mais également par le déplacement dans un champ magnétique statique et variable.

Le calcul du courant induit peut être précis, et distinguer un courant induit pour différents organes de l'opérateur 200, à partir de modèles connus de la conductivité d'un être humain.

Ce courant induit peut être considéré comme étant un indicateur global d'exposition, représentatif de conditions d'exposition auxquelles est soumis l'opérateur 200.

L'indicateur global d'exposition est avantageusement calculé en temps réel, et par les moyens de calcul 4.

Les moyens de calcul 4 peuvent comparer cet indicateur global d'exposition à un seuil prédéterminé, et le cas échéant activer en temps réel des moyens d'émission d'un signal d'alerte 5.

Les moyens d'émission d'un signal d'alerte 5 peuvent être :

- un voyant lumineux ; et/ou
- un haut parleur pour émettre un signal sonore.

L'activation des moyens d'émission d'un signal d'alerte 5 est symbolisée par la flèche 41.

Cette activation n'est mise en oeuvre que si l'indicateur global d'exposition calculé par les moyens de calcul dépasse le seuil prédéterminé pour ledit indicateur global d'exposition.

On va maintenant décrire, en référence à la figure 2, un deuxième mode de réalisation d'un appareil de surveillance 1 selon l'invention.

La figure 2 ne sera décrite que pour ses différences à l'égard de la figure 1.

A la figure 2, l'appareil 1 selon l'invention comprend en outre :

- un module portatif 6 de mesure d'une énergie radiofréquence ;
- un module portatif 7 de mesure d'un niveau sonore ; et
- un module portatif 90 de mesure d'une position relative de l'opérateur 200.

Le module portatif 6 calcule une énergie radiofréquence absorbée par l'opérateur 200. Cette énergie décroît très vite lorsqu'on s'éloigne de l'appareil IRM. Par exemple, le module 6 n'est mis en oeuvre que si l'opérateur 200 se trouve à l'intérieur de l'appareil IRM.

Le module portatif 6 de mesure d'une énergie radiofréquence envoie ses mesures vers les moyens de calcul 4 (l'envoi étant symbolisé par la flèche 61).

Le module portatif 7 mesure un niveau sonore auquel est soumis l'opérateur 200. Il peut être formé par un capteur piézoélectrique de vibrations sonores.

La puissance acoustique à proximité d'un appareil IRM peut atteindre 110 dB acoustiques, alors que la limite impliquant l'obligation de porter des dispositifs de protection individuelle est fixée à 80 dB acoustiques. Il est donc important de prendre en compte la puissance acoustique pour évaluer des conditions d'exposition d'un opérateur 200.

Le module portatif 7 de mesure d'un niveau sonore envoie ses mesures vers les moyens de calcul 4 (l'envoi étant symbolisé par la flèche 71).

Les moyens de calcul 4, à partir des mesures reçues, peuvent calculer un indicateur global d'exposition prenant en compte non seulement le courant induit calculé, mais également les autres mesures ou calculs effectuées.

Cet indicateur global d'exposition est comparé à un seuil prédéterminé de façon à activer les moyens d'émission d'un signal d'alerte 5 lorsque ce seuil est dépassé.

L'opérateur 200 reçoit donc le cas échéant un signal d'alerte représentatif d'une exposition à différents facteurs de risques pour sa santé.

L'intérêt d'un indicateur global est notamment de pouvoir compenser un risque plus élevé dans un domaine par un risque moins élevé dans un autre domaine. Par exemple, un risque élevé lié à un niveau sonore élevé mais un risque faible lié aux courants induits pourra conduire à un même indicateur global qu'un risque faible lié à un niveau sonore élevé mais un risque élevé lié aux courants induits.

Naturellement, on peut aussi prévoir que les moyens d'émission d'un signal d'alerte prennent en compte des seuils d'exposition distincts pour le courant induit d'une part, et pour chaque donnée indicative hors accélération et champ magnétique d'autre part, avec un signal d'alerte distinct correspondant.

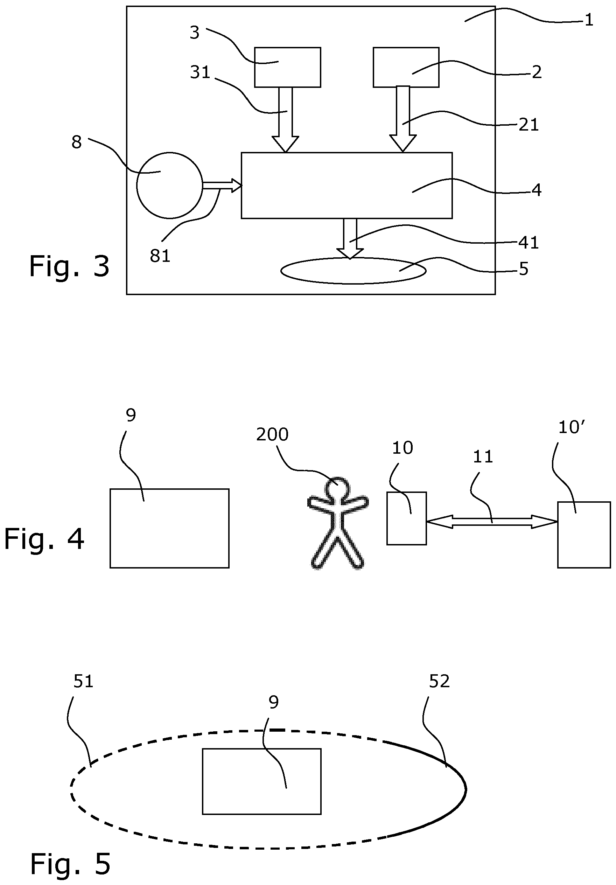

Le module portatif 90 de mesure d'une position relative de l'opérateur 200 comprend un IMU. Il envoie ses mesures vers les moyens de calcul 4 (l'envoi étant symbolisé par la flèche 91). Plus de précisions seront données en référence à la figure 5.

L'IMU comprend un gyroscope et un accéléromètre. Le gyroscope seul fourni uniquement les angles d'Euler permettant de déterminer en temps réel comment les axes du référentiel du dispositif portatif bougent par rapport à un référentiel. La position relative est déterminée en reliant ces données aux valeurs fournies par l'accéléromètre. Le module portatif 90 de mesure d'une position relative de l'opérateur 200 et le module portatif 3 pour déterminer une vitesse de déplacement peuvent partager un même accéléromètre.

On va maintenant décrire, en référence à la figure 3, un troisième mode de réalisation d'un appareil de surveillance 1 selon l'invention.

La figure 3 ne sera décrite que pour ses différences à l'égard de la figure 1.

A la figure 3, l'appareil 1 selon l'invention comprend des moyens d'alerte 8, qui peuvent être activés pour signaler un malaise.

Les moyens d'alerte 8 peuvent être formés par :

- un simple bouton poussoir,
- un récepteur audio suivi de moyens de reconnaissance vocale pour identifier un message audio indiquant un malaise de l'opérateur 200,
- etc.

Il s'agit de prendre en compte le fait qu'un seuil de confort peut varier d'un individu à l'autre.

Grâce aux moyens d'alerte 8, l'opérateur 200 envoie en temps réel vers les moyens de calcul 4 (voir flèche 81) l'information selon laquelle il ressent un malaise.

On pourrait également prévoir que cet avertissement ne soit pas en temps réel, l'opérateur pouvant indiquer par la suite à quelle heure le malaise a été ressenti. Dans ce cas, cela suppose que les différentes données mesurées soient enregistrées et conservées au moins provisoirement, et que l'appareil 1 selon l'invention soit horodaté.

Les moyens de calcul 4 reçoivent l'information d'un malaise de l'utilisateur. En utilisant les données mesurées à l'instant de ce malaise, les moyens de calcul 4 calculent l'indicateur global d'exposition à cet instant, et attribuent cette valeur de l'indicateur global d'exposition au seuil prédéterminé pour l'indicateur global d'exposition.

On peut prévoir que les moyens d'alerte 8 soient agencés pour que l'opérateur puisse préciser la nature du malaise. On pourra ainsi identifier la source du malaise.

Cette précision peut être apportée plus tard, par exemple en fin de journée, par l'opérateur 200.

On pourra alors obtenir un seuil d'exposition correspondant à une donnée indicative particulière (hors accélération et champ magnétique) ou seulement au courant induit.

Le seuil pour l'indicateur global d'exposition pourra être affiné peu à peu, à partir de seuils d'exposition ainsi déterminés.

On va maintenant décrire, en référence à la figure 4, un quatrième mode de réalisation d'appareil 1 selon l'invention.

Selon ce mode de réalisation, l'appareil 1 se divise en un dispositif portatif 10, porté par l'opérateur 200, et une base 10' non embarquée et dans laquelle est effectuée une partie des calculs.

Le dispositif portatif 10 est miniaturisé (circuits intégrés et pontages) pour faciliter son usage quotidien par des travailleurs. Un autre avantage de sa miniaturisation est que l'on réduit ainsi les interférences avec l'environnement magnétique. Les dimensions du dispositif portatif 10 peuvent être par exemple inférieures à 40x20x10 mm$^3$.

On peut prévoir que l'ensemble des moyens de calcul 4 soit situé dans la base 10'.

Une communication bidirectionnelle 11 entre la base 10' et le dispositif portatif 10 permet que :

- le dispositif portatif 10 envoie à la base 10' les mesures effectuées ;
- la base 10' envoie au dispositif portatif 10 une information d'activation de moyens d'émission d'un signal d'alerte 5 (ces moyens 5 étant situés dans le dispositif portatif 10), par exemple lorsque l'indicateur global d'exposition calculé dépasse un seuil donné ;
- les moyens d'alerte 8 situés sur le dispositif portatif 10 envoient à la base 10' une information indiquant qu'ils ont été activés.

Cette communication bidirectionnelle peut être en temps réel.

On peut également prévoir que la base 10' comporte uniquement des moyens de stockage des différentes données mesurées et/ou calculées à chaque instant, éventuellement pour plusieurs opérateurs 200.

Le cas échéant la base 10' comporte des moyens de réalisation d'une cartographie (moyens de stockage de couples formés par une donnée de localisation et un courant induit ainsi qu'éventuellement une ou plusieurs données indicatives mesurées).

Cette communication bidirectionnelle peut être alors facilement en temps différé : on peut reposer le dispositif portatif 10 sur la base 10' après chaque utilisation, et lancer alors un transfert de données du dispositif portatif 10 vers la base 10'.

Dans ce cas, le dispositif portatif 10 comprend des moyens de stockage provisoire, par exemple pour stocker des données mesurées à chaque instant pendant une journée. La base 10' comprend alors des moyens de stockage à long terme, par exemple pour stocker des données mesurées à chaque instant pendant plusieurs années.

Grâce à ces données sur plusieurs années, il sera possible d'effectuer des études sanitaires sur le long terme. On pourra notamment étudier l'impact sanitaire des effets de dose pour les différentes données mesurées, et pour les courants induits calculés.

On peut également prévoir que la base 10' stocke des données mesurées/calculées en vue d'établir des cartographies relatives à des conditions d'exposition autour d'un appareil IRM donné (voir plus loin).

Selon un autre aspect de l'invention, comme vu précédemment, le dispositif portatif 10 selon l'invention comprend un module portatif 90 de mesure d'une position relative de l'opérateur 200.

La position relative de l'opérateur peut être déterminée en référence à la position de la base 10', qui est alors de préférence fixe, tout comme l'appareil 9 utilisant la technologie de résonance magnétique.

Les données mesurées (champ magnétique, puissance sonore, énergie radiofréquence) peuvent alors être utilisées pour cartographier, par exemple une pièce donnée où se trouve un appareil IRM.

Cette cartographie peut permettre de réaliser des moyens de guidage visuels pour aider un opérateur 200 à limiter les risques pour sa santé lorsqu'il évolue à proximité d'un appareil IRM 9. Cette cartographie, contrairement à des données constructeur qui peuvent être fournies par un fabricant d'appareil IRM, correspondent à des mesures concrètes, réelles, précises. Cette cartographie peut être mise à jour régulièrement, en fonction des mesures effectuées à chaque instant à proximité de l'appareil IRM 9.

La figure 5 montre en vue de dessus un appareil IRM 9 et des moyens de guidage visuels réalisés autour, par exemple sous la forme de peintures au sol.

Une forme ovale 51 dessinée en pointillé autour de l'appareil IRM 9 indique à l'opérateur 200 un trajet recommandé. On peut aussi parler d'itinéraire optimum.

Une portion 52 est en trait plein : cela signifie que sur cette portion de trajet, l'opérateur 200 doit diminuer sa vitesse (ce qui va limiter le courant induit qui le traverse).

Plutôt que des lignes de trajectoires, on peut aussi délimiter des surfaces, avec par exemple des codes couleurs en fonction d'un niveau de risque encouru.

Selon un autre aspect de l'invention, les éléments de cartographie obtenus peuvent être utilisés pour optimiser une ergonomie d'une pièce où se trouve un appareil IRM en fonctionnement : en plaçant des rangements à des endroits stratégiques, on peut limiter l'exposition des travailleurs (soit en limitant des déplacements inutiles, soit en limitant leurs passages par des zones plus dangereuses).

Ces modes de réalisation étant nullement limitatifs, on pourra notamment imaginer des variantes de l'invention ne comprenant qu'une sélection de caractéristiques décrites isolées des autres caractéristiques décrites, si cette sélection de caractéristiques est suffisante pour conférer un avantage technique ou pour différencier l'invention par rapport à l'état de la technique antérieure.

Bien sûr, l'invention n'est pas limitée aux exemples qui viennent d'être décrits et de nombreux aménagements peuvent être apportés à ces exemples sans sortir du cadre de l'invention.

En particulier tous les modes de réalisation décrits précédemment sont combinables entre eux selon diverses combinaisons dans la mesure où ils ne sont pas incompatibles ou exclusifs les uns des autres.

## Revendications

1. Appareil de surveillance (1) de conditions d'exposition auxquelles est soumis un opérateur (200) ou une machine situé dans un environnement magnétique, comprenant un dispositif portatif (10) agencé pour être embarqué sur l'opérateur (200) ou la machine, ledit dispositif portatif (10) comprenant des modules portatifs parmi lesquels un module portatif (2) de mesure, à plusieurs instants t connus, d'une donnée indicative comprenant les trois composantes d'un vecteur de champ magnétique, l'appareil étant **caractérisé en ce que** :

   - le dispositif portatif (10) comprend en outre un module portatif (3) de mesure d'une donnée indicative permettant de déterminer les trois composantes d'un vecteur de vitesse de déplacement aux instants t connus ; et
   - l'appareil de surveillance (1) comprend des moyens de calcul (4) comprenant des moyens pour calculer une estimation d'un courant induit traversant l'opérateur ou la machine, à partir des vecteurs de champ magnétique et de vitesse de déplacement aux instants t connus.

2. Appareil (1) selon la revendication 1, **caractérisé en ce que** les modules portatifs comprennent en outre un module portatif (6) de mesure d'une donnée indicative comprenant une énergie radiofréquence.

3. Appareil (1) selon la revendication 1 ou 2, **caractérisé en ce que** les modules portatifs comprennent en outre un module portatif (7) de mesure d'une donnée indicative comprenant un niveau sonore.

4. Appareil (1) selon l'une quelconque des revendications 1 à 3, **caractérisé en ce qu'**il comprend des moyens de calcul (4) comprenant des moyens pour calculer un indicateur global d'exposition prenant en compte chaque donnée indicative et pour activer des moyens d'émission d'un signal d'alerte (5) lorsque l'indicateur global d'exposition dépasse un seuil prédéterminé.

5. Appareil (1) selon l'une quelconque des revendications 1 à 4, **caractérisé en ce que** le dispositif portatif comprend des moyens d'alerte (8) agencés pour signaler une sensation de malaise lorsqu'ils sont activés, et **en ce que** l'appareil (1) comprend des moyens de calcul (4) comprenant des moyens pour prendre en compte une donnée provenant de ces moyens d'alerte (8) afin de déterminer un seuil d'exposition.

6. Appareil (1) selon l'une quelconque des revendications 1 à 5, **caractérisé en ce que** les modules portatifs comprennent en outre un module portatif (90) de mesure d'une donnée indicative comprenant une position relative de l'opérateur (200) ou de la machine.

7. Appareil (1) selon l'une quelconque des revendications 1 à 6, **caractérisé en ce qu'**au moins une partie des moyens de calcul (4) est placée dans le dispositif portatif (10).

8. Procédé de surveillance comprenant une étape de mesure répétée à plusieurs instants t connus, d'une donnée indicative comprenant les trois composantes d'un vecteur de champ magnétique auquel est soumis un opérateur (200) ou une machine, le procédé étant **caractérisé en ce qu'**il est mis en oeuvre pour la surveillance de conditions d'exposition auxquelles est soumis l'opérateur ou la machine lorsqu'il respectivement elle se trouve dans un environnement magnétique, ainsi que par les étapes suivantes :

- détermination, en utilisant un module portatif pour déterminer une vitesse, porté par l'opérateur ou la machine, des trois composantes d'un vecteur de vitesse de déplacement de l'opérateur (200) ou de la machine aux instants t connus ; puis
- en utilisant les vecteurs de champ magnétique et de vitesse de déplacement aux instants t connus, calcul d'une estimation d'un courant induit traversant l'opérateur (200) ou la machine.

9. Procédé de surveillance selon la revendication 8, **caractérisé en ce que** l'on mesure en outre une donnée indicative comprenant une énergie radiofréquence à laquelle est soumis l'opérateur (200) ou la machine.

10. Procédé de surveillance selon la revendication 8 ou 9, **caractérisé en ce que** l'on mesure en outre une donnée indicative comprenant un niveau sonore auquel est soumis l'opérateur (200) ou la machine.

11. Procédé de surveillance selon l'une quelconque des revendications 8 à 10, **caractérisé en ce que** chaque donnée indicative est prise en compte pour calculer un indicateur global d'exposition.

12. Procédé de surveillance selon la revendication 11, **caractérisé en ce qu'**un signal d'alerte est émis lorsque l'indicateur global d'exposition dépasse un seuil prédéterminé.

13. Procédé de surveillance selon l'une quelconque des revendications 8 à 12, **caractérisé par** les étapes suivantes :

- l'opérateur (200) signale, via des moyens d'alerte (8), une sensation de malaise ; puis
- on en déduit un seuil d'exposition.

14. Procédé de surveillance selon l'une quelconque des revendications 8 à 13, **caractérisé en ce que** l'on mesure en outre une position relative de l'opérateur (200) ou de la machine, et **en ce qu'**on réalise une cartographie d'une donnée indicative mesurée.

15. Procédé de surveillance selon la revendication 14, **caractérisé en ce qu'**il est mis en oeuvre à proximité d'une source de champ magnétique telle qu'un appareil (9) utilisant la technologie de résonance magnétique et **en ce qu'**on réalise des moyens de guidage visuels (51, 52) à proximité de ladite source de champ magnétique, de façon à :

- mettre en évidence un trajet recommandé à proximité de la source de champ magnétique ; et/ou
- mettre en évidence au moins une zone à proximité de la source de champ magnétique, et à l'intérieur de laquelle la vitesse de l'opérateur (200) ou de la machine doit être réduite.

**Patentansprüche**

1. Überwachungsgerät (1) zum Überwachen von Expositionsbedingungen, denen zumindest ein Bediener (200) bzw. eine Maschine ausgesetzt ist, der/die sich in einem magnetischen Umfeld befindet, enthaltend eine tragbare Vorrichtung (10), die dazu ausgebildet ist, vom Bediener (200) oder von der Maschine mitgeführt zu werden, wobei die tragbare Vorrichtung (10) tragbare Module aufweist, darunter ein tragbares Messmodul (2) zum Messen einer Größe zu mehreren bekannten Zeitpunkten t, die drei Komponenten eines Magnetfeldvektors umfasst, wobei das Gerät **dadurch gekennzeichnet ist, dass**

- die tragbare Vorrichtung (10) ferner ein tragbares Messmodul (3) zum Messen einer Größe umfasst, mit dem die drei Komponenten eines Verlagerungsgeschwindigkeitsvektors zu den bekannten Zeitpunkten t bestimmt werden können; und
- das Überwachungsgerät (1) Recheneinrichtungen (4) enthält, die Einrichtungen zum Berechnen einer Schätzung eines induzierten Stroms enthalten, der ausgehend von den Magnetfeld- und Verlagerungsgeschwindigkeitsvektoren zu den bekannten Zeitpunkten t durch den Bediener oder durch die Maschine fließt.

2. Gerät (1) nach Anspruch 1, **dadurch gekennzeichnet, dass** die tragbaren Module ferner ein tragbares Messmodul (6) zum Messen einer Größe enthalten, die eine Hochfrequenzenergie enthält.

3. Gerät (1) nach Anspruch 1 oder 2, **dadurch gekennzeichnet, dass** die tragbaren Module ferner ein tragbares Messmodul (7) zum Messen einer Größe enthalten, die einen Schallpegel enthält.

4. Gerät (1) nach einem der Ansprüche 1 bis 3, **dadurch gekennzeichnet, dass** es Recheneinrichtungen (4) enthält, die Einrichtungen zum Berechnen eines Expositionsgesamtindikators unter Berücksichtigung jeder Größe und zum Aktivieren von Ausgabeeinrichtungen zum Ausgeben eines Warnsignals (5), wenn der Expositionsgesamtindikator einen vorbestimmten Schwellwert übersteigt, aufweisen.

5. Gerät (1) nach einem der Ansprüche 1 bis 4, **dadurch gekennzeichnet, dass** die tragbare Vorrichtung Warneinrichtungen (8) aufweist, die dazu ausgebildet sind, ein Gefühl von Unwohlsein zu melden, wenn sie aktiviert sind, und dass das Gerät (1) Recheneinrichtungen (4) aufweist, die Einrichtungen zum Berücksichtigen einer Größe aufweisen, die von diesen Warneinrichtungen (8) stammt, um einen Expositionsschwellwert zu bestimmen.

6. Gerät (1) nach einem der Ansprüche 1 bis 5, **dadurch gekennzeichnet, dass** die tragbaren Module ferner ein tragbares Messmodul (90) zum Messen einer Größe enthalten, die eine relative Position des Bedieners (200) oder der Maschine enthält.

7. Gerät (1) nach einem der Ansprüche 1 bis 6, **dadurch gekennzeichnet, dass** zumindest ein Teil der Recheneinrichtungen (4) in der tragbaren Vorrichtung (10) angeordnet ist.

8. Überwachungsverfahren, umfassend einen Schritt des zu mehreren bekannten Zeitpunkten t wiederholten Messens einer Größe mit drei Komponenten eines Magnetfeldvektors, dem ein Bediener (200) oder eine Maschine ausgesetzt ist, wobei das Verfahren **dadurch gekennzeichnet ist, dass** es zum Überwachen von Expositionsbedingungen durchgeführt wird, denen der Bediener bzw. die Maschine ausgesetzt ist, wenn er bzw. sie sich in einem magnetischen Umfeld befindet, sowie durch die nachfolgenden Schritte:

   - Bestimmen der drei Komponenten eines Verlagerungsgeschwindigkeitsvektors des Bedieners (200) bzw. der Maschine zu den bekannten Zeitpunkten t, indem ein tragbares Modul zum Bestimmen einer Geschwindigkeit verwendet wird, das von dem Bediener bzw. der Maschine getragen wird, dann
   - Berechnen einer Abschätzung eines induzierten Stroms, der durch den Bediener (200) bzw. die Maschine fließt, unter Verwendung der Magnetfeld- und Verlagerungsgeschwindigkeitsvektoren zu den bekannten Zeitpunkten t.

9. Überwachungsverfahren nach Anspruch 8, **dadurch gekennzeichnet, dass** ferner eine Größe gemessen wird, die eine Hochfrequenzenergie enthält, welcher der Bediener (200) bzw. die Maschine ausgesetzt ist.

10. Überwachungsverfahren nach Anspruch 8 oder 9, **dadurch gekennzeichnet, dass** ferner eine Größe gemessen wird, die einen Schallpegel enthält, welchem der Bediener (200) bzw. die Maschine ausgesetzt ist.

11. Überwachungsverfahren nach einem der Ansprüche 8 bis 10, **dadurch gekennzeichnet, dass** jede Größe zum Berechnen eines Expositionsgesamtindikators berücksichtigt wird.

12. Überwachungsverfahren nach Anspruch 11, **dadurch gekennzeichnet, dass** ein Warnsignal ausgegeben wird, wenn der Expositionsgesamtindikator einen vorbestimmten Schwellwert übersteigt.

13. Überwachungsverfahren nach einem der Ansprüche 8 bis 12, **gekennzeichnet durch** die nachfolgenden Schritte:

   - der Bediener (200) meldet über Warneinrichtungen (8) ein Gefühl von Unwohlsein, wonach
   - ein Expositionsschwellwert davon abgeleitet wird.

14. Überwachungsverfahren nach einem der Ansprüche 8 bis 13, **dadurch gekennzeichnet, dass** ferner eine relative Position des Bedieners (200) bzw. der Maschine gemessen wird und eine Kartografie einer gemessenen Größe erstellt wird.

15. Überwachungsverfahren nach Anspruch 14, **dadurch gekennzeichnet, dass** es in der Nähe einer Magnetfeldquelle, wie etwa eines Geräts (9), bei dem die Magnetresonanztechnologie angewendet wird, durchgeführt wird und visuelle Führungseinrichtungen (51, 52) in der Nähe der Magnetfeldquelle eingesetzt werden, so dass:

   - eine empfohlene Wegstrecke in der Nähe der Magnetfeldquelle angeführt wird; und/oder
   - zumindest ein Bereich in der Nähe der Magnetfeldquelle angeführt wird, innerhalb dessen die Geschwindigkeit des Bedieners (200) bzw. der Maschine vermindert werden muss.

**Claims**

1. Apparatus (1) for monitoring exposure conditions to which an operator (200) or a machine situated in a magnetic environment is subjected, comprising a portable device (10) arranged to be carried on the operator (200) or on the machine, said portable device (10) comprising portable modules including a portable module (2) for measuring, at several known times t, an indicative item of data comprising the three components of a magnetic field vector, the apparatus being **characterized in that**:

   - the portable device (10) further comprises a portable module (3) for measuring an indicative item of data making it possible to determine the three components of a movement speed vector at known times t; and
   - the monitoring apparatus (1) comprises calculation means (4) comprising means for calculating an estimation of an induced current passing though the operator or the machine, from the magnetic field and movement speed vectors at known times t.

2. Apparatus (1) according to claim 1, **characterized in that** the portable modules further comprise a portable module (6) for measuring an indicative item of data comprising radio-frequency energy.

3. Apparatus (1) according to claim 1 or 2, **characterized in that** the portable modules further comprise a portable module (7) for measuring an indicative item of data comprising a sound level.

4. Apparatus (1) according to any one of claims 1 à 3, **characterized in that** it comprises calculation means (4) comprising means for calculating an overall exposure indicator taking account of each indicative item of data and for activating means for transmitting a warning signal (5) when the overall exposure indicator exceeds a predetermined threshold.

5. Apparatus (1) according to any one of claims 1 à 4, **characterized in that** the portable device comprises warning means (8) arranged to signal a feeling of discomfort when they are activated, and **in that** the apparatus (1) comprises calculation means (4) comprising means for taking into account an item of data from these warning means (8) in order to determine an exposure threshold.

6. Apparatus (1) according to any one of claims 1 à 5, **characterized in that** the portable modules further comprise a portable module (90) for measuring an indicative item of data comprising a relative position of the operator (200) or of the machine.

7. Apparatus (1) according to any one of claims 1 à 6, **characterized in that** at least a part of the calculation means (4) is placed in the portable device (10).

8. Monitoring method comprising a measuring step repeated at several known times t, an indicative item of data comprising the three components of a magnetic field vector to which an operator (200) or a machine is subjected, the method being **characterized in that** it is implemented for monitoring exposure conditions to which the operator or the machine is subjected when located, respectively, in a magnetic environment, as well as by the following steps:

   - determining, by using a portable module to determine a speed, carried by the operator or the machine, the three components of a movement speed vector of the operator (200) or of the machine at known times t; then
   - by using the magnetic field and movement speed vectors at known times t, calculating an estimation of an induced current passing through the operator (200) or the machine.

9. Monitoring method according to claim 8, **characterized in that** an indicative item of data is moreover measured comprising radio-frequency energy to which the operator (200) or the machine is subjected.

10. Monitoring method according to claim 8 or 9, **characterized in that** an indicative item of data is moreover measured comprising a sound level to which the operator (200) or the machine is subjected.

11. Monitoring method according to any one of claims 8 to 10, **characterized in that** each indicative item of data is taken into account for calculating an overall exposure indicator.

12. Monitoring method according to claim 11, **characterized in that** a warning signal is transmitted when the overall exposure indicator exceeds a predetermined threshold.

13. Monitoring method according to any one of claims 8 à 12, **characterized by** the following steps :

- the operator (200) signals, via warning means (8),a feeling of discomfort; then
- an exposure threshold is deduced therefrom.

14. Monitoring method according to any one of claims 8 à 13, **characterized in that** a relative position of the operator (200) or of the machine is moreover measured, and **in that** a mapping of a measured indicative item of data is produced.

15. Monitoring method according to claim 14, **characterized in that** it is implemented close to a magnetic field source such as an apparatus (9) using magnetic resonance technology, and **in that** visual guide means (51, 52) close to said magnetic field source are produced, so as to:

- indicate a recommended route close to the magnetic field source; and/or
- indicate at least one area close to the magnetic field source, within which the speed of the operator (200) or of the machine must be reduced.

Fig. 1

Fig. 2

Fig. 3

Fig. 4

Fig. 5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **KARPOWICZ.** Assessment of induced currents hazards among health care workers operating magnetic resonance scanners - towards new standardization approach. *APPLIED SCIENCES IN BIOMEDICAL AND COMMUNICATION TECHNOLOGIES,* 2009

- Basic anatomical and physiological data for use in radiological protection: référence values. *ICRP,* 2002, 84